Europäisches Patentamt

European Patent Office

Office européen des brevets

(19)

(11) Publication number: 0 058 080
A2

# (12) EUROPEAN PATENT APPLICATION

(21) Application number: 82300621.8

(22) Date of filing: 09.02.82

(51) Int. Cl.³: H 01 R 23/72

(30) Priority: 09.02.81 US 232772

(43) Date of publication of application:
18.08.82 Bulletin 82/33

(84) Designated Contracting States:
DE FR GB IT

(71) Applicant: MOTOROLA, INC.
1303 East Algonquin Road
Schaumburg Illinois 60196(US)

(72) Inventor: Latasiewicz, Leonard
1342 West Oakmont Road
Hoffman Estates Illinois 60194(US)

(72) Inventor: Estes, Bay E., III
915 Carmel
Palatine Illinois 60067(US)

(72) Inventor: Scheuer, Paul R.
1789 Dogwood Court
Hoffman Estates Illinois 60195(US)

(74) Representative: Ibbotson, Harold
Motorola Limited Armstrong Road Daneshill East
Basingstoke Hants RG24 9NN(GB)

(54) Binary code assembly.

(57) A programmable binary code assembly (10) is disclosed wherein the metal chassis (14a, 15, 16) of a standard flat cable clamp connector (14) is used in conjunction with metallizations (12 and 13) on a printed circuit board (11) and a flat insulating sheet (17) comprising a number of flexible extending insulating fingers (20). The metal chassis comprises a number of individual spring fingers (16) which normally electrically and mechanically contact associated isolated printed circuit board metallizations (12). A portion (17a) of the flat insulating sheet (17) is inserted between the printed circuit board metallizations (12) and the metal chassis (14a, 15, 16) and the extending insulating fingers (20) are selectively bent prior to insertion to provide for the selective shorting together of a number of the printed circuit board metallizations (12) by the spring fingers (16).

EP 0 058 080 A2

# BINARY CODE ASSEMBLY

## Background of the Invention

The present invention relates generally to the field of binary code assemblies wherein components are assembled or adjusted to create a predetermined binary code through the selective interconnection of conductors. The present invention is more specifically related to such binary code assemblies which are user programmable which means that the binary code can be altered by the user from one code to another.

A number of different binary code assemblies and programmable binary code assemblies are known. The majority of these assemblies comprise dual in-line integrated circuit packages and their mating sockets, and the majority of these are non-programmable in that once the device has been modified to provide a predetermined binary code, the device cannot be readily altered so that a different predetermined binary code can be implemented.

Programmable binary code assemblies which were previously known either had limited programmability, and/or were programmable only with the assistance of special tools such as requiring solder bridging to reconnect previously sheared conductor paths, and/or comprised complex and costly mechanical structures which would make these assemblies unfeasible for use in consumer product applications wherein the cost of the code assembly must be minimized.

0058080

## Summary of the Invention

An object of the present invention is to provide an improved binary code assembly which overcomes the deficiencies of the prior art assemblies noted above.

A more particular object of the present invention is to provide an improved binary code assembly which is inexpensive, contains relatively few components, can be assembled without the use of special tools, and is readily user programmable to alter the binary code without the use of special tools.

In one embodiment of the present invention, a binary code assembly is provided comprising: a circuit board having a plurality of isolated conductor paths thereon; metallic conductor means having a main metallic body and a plurality of individual metallic spring fingers extending from said metallic body and electrically connected thereto, said metallic connector means mounted on said circuit board with each spring finger positioned adjacent to an associated one of said isolated circuit board conductor paths, said connector means mounted such that each of said spring fingers normally matingly electrically and mechanically contacts its associated conductor path via the mechanical bias provided by the spring finger; and insulating means comprising a relatively thin sheet of insulating material, a portion of said sheet being inserted into a fixed position between said connector means and said circuit board, said insulating means formed to provide for the selective interconnection of some of the circuit board conductor paths while maintaining other of said circuit board conductor paths isolated by said inserted portion being interposed between these conductor paths and their associated spring fingers, thereby creating a binary code through the selective shorting together of said some of said circuit board conductor paths.

Preferably, a standard component normally utilized as a flat cable connector clamp is mounted to a conventional printed circuit board having a plurality of conductor metallizations forming the conductive paths referred to above. The cable clamp has a number of spring fingers which will normally contact associated conductor metallizations on the printed circuit board. To this two component assembly a portion of a flat sheet of insulating material is interposed therebetween to provide for the selective isolating of some of the spring fingers from their associated conductor metallizations. Preferably, the inserted portion of the flat insulating sheet comprises a number of insulating fingers which can be readily manually bent such that the user can determine, prior to the insertion of the flat sheet, which of the spring fingers should be isolated from their associated conductor metallizations. In this manner, the binary code assembly of the present invention is readily manually programmable.

Additional features of the present invention are that a binary code assembly is provided which consists of only three elements all of which are of a simplified construction and are relatively inexpensive. Preferably the insulating sheet is formed from a Mylar sheet of 5-15 mils. (thousands of an inch) in thickness. Also, preferably the cable clamp connector has locating projections which mate with notches in the insulating sheet to hold the sheet in place once it has been inserted between the printed circuit board and the cable clamp. In addition, it is contemplated that the spring fingers of the cable clamp will be formed such that they provide a curved surface adjacent to the point of contact between them and their associated printed circuit conductor metallization such that the insertion of the portion of the insulating sheet between these elements is facilitated.

Through the use of the above recited structural limitations for the binary code assembly of the present invention, as well as due to other structural limitations to be described hereinafter, the present invention has provided a binary code assembly which is vastly superior to previous known assemblies with regard to cost, ease of assembly, complexity, and ease of adjusting the assembly to provide various different binary codes (programmability).

Brief Description of the Drawings

For a more complete understanding of the present invention, reference should be made to the drawings, in which:

FIG. 1 is an exploded perspective view of the binary code assembly of the present invention;

FIG. 2 is a perspective view of the components in FIG. 1 after partial assembly;

FIG. 3 is a perspective view of the components in FIGS. 1 and 2 after complete assembly;

FIG. 4 is a cross-sectional view of the completed assembly show in FIG. 3 taken along the lines 4-4 ;

FIG. 5 is a cross-sectional view of the completed assembly shown in FIG.4 taken along the lines 5-5; and

FIG. 6 is a perspective view of an alternate embodiment for one of the components of the binary code assembly shown in FIGS. 1-3.

Description of the Preferred Embodiments

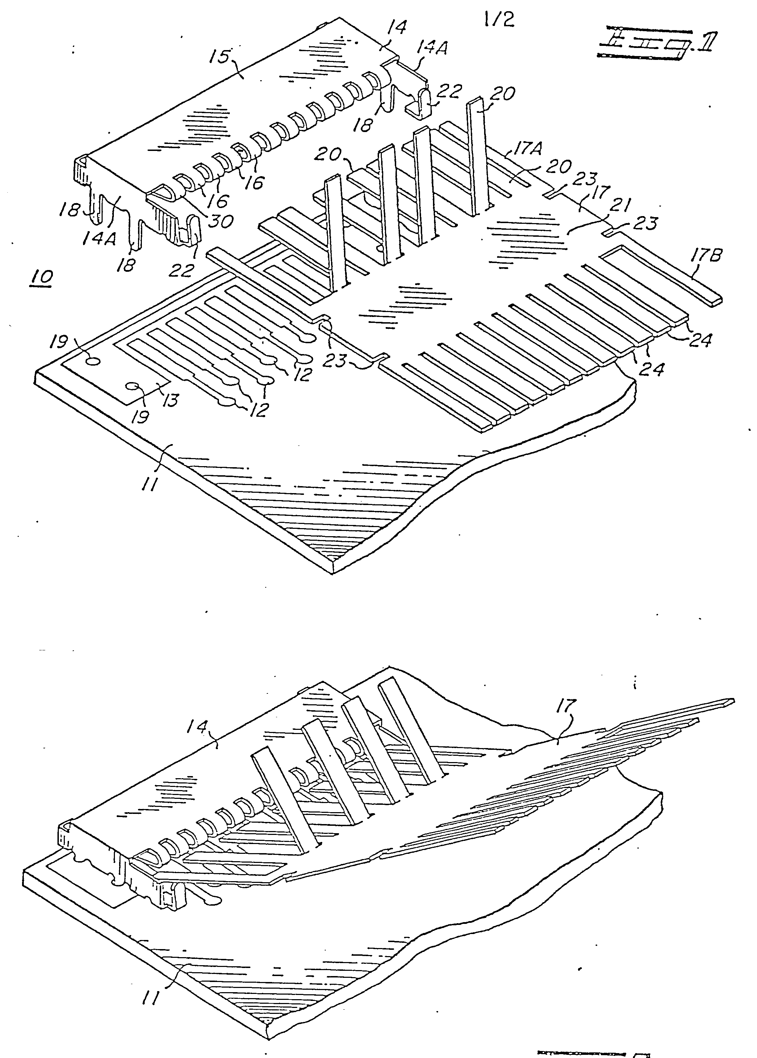

FIG. 1 illustrates a binary code assembly 10 which basically comprises a printed circuit board 11 having a plurality of isolated conductor metallizations 12 thereon and a surrounding outer conductor metallization 13, a metallic connector 14 having a metal chassis which includes connector sides 14a, a main metallic body 15 and a plurality of individual metallic spring fingers 16 extending from the main body, and an insulating element comprising a relatively thin sheet 17 of insulating material having a portion 17a intended to be inserted between the connector 14 and the printed circuit board 11. The connector 14 is contemplated as preferably having four downward extending mounting tab projections 18 which are to be received in and through corresponding holes 19 in the printed circuit board so as to mount the connector 14 to the printed circuit board.

While the present invention preferably utilizes a printed circuit board 11 of conventional construction having copper conductive metallizations, other types of circuit boards can be utilized. These circuit boards could comprise for example, any insulating base substrate with a plurality of conductive paths thereon, wherein these paths can be formed with conductive carbon ink.

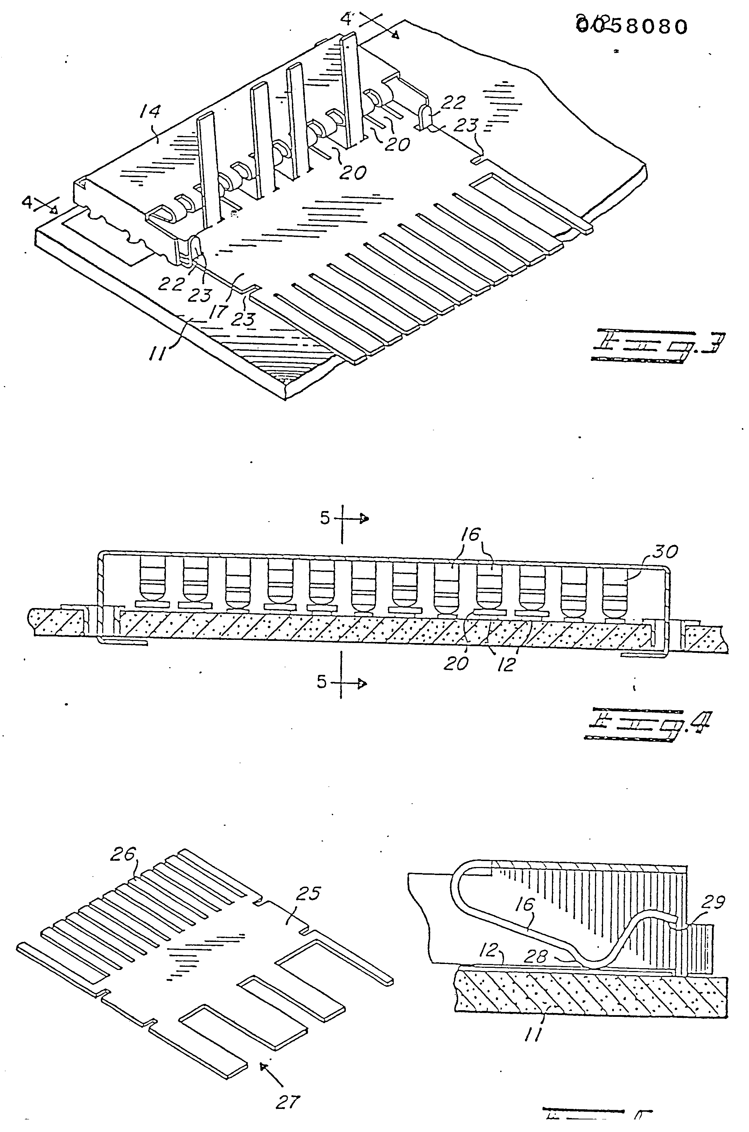

The subassembly comprising the connector 14 mounted to the printed circuit board 11 prior to the insertion of the portion 17a of the insulating sheet 17 is illustrated in FIG. 2. The metallic connector 14 is mounted to the printed circuit board 11 such that each of the flexible metallic spring fingers 16 is positioned adjacent to an associated one of the plurality of isolated printed circuit board metallizations 12 such that each of the spring fingers 16 will normally matingly electrically and mechanically contact just its associated conductor metallization via mechanical spring bias which is provided by the spring finger. It should be noted that after the connector 14 is fixed to the printed circuit board 11, it is contemplated that the metallic chassis of the connector, which includes the main metallic body 15 and the spring fingers 16, will always be electrically connected to one of the printed circuit board metallizations 12 by virtue of a single one 30 of the fingers 16 always mechanically contacting this metallization regardless of the electrical connections formed by the other spring fingers 16.  This technique eliminates the need to solder the connector 14 to the printed circuit board 11.  This connection could also be made by the mechanical contact of the sides 14a of the connector 14 to the metallization 13 or via a solder connection.  Due to the aforedescribed construction of the connector 14 and printed circuit board 11, it should be clear that all of the metallizations 12 on the printed circuit board will be connected together after the assembly of the connector 14 to the printed circuit board 11.

Preferably, the sheet 17 of insulating material comprises at  least one set of a plurality of individual flexible extending fingers 20 which extend outward from a central carrier strip portion 21 of the insulating sheet 17 and form the portion 17a to be inserted between the connector 14 and the printed circuit board.  Each of the insulating fingers 20 is dimensioned such that. it is capable of forming an insulating barrier between one of the spring fingers 16 and its associated conductor metallization 12 when the sheet portion 17a is inserted between the metallic connector means 14 and the printed circuit board 11.

It is also contemplated that each of the insulating fingers 20 is capable of being selectively manually bent, prior to the insertion of the sheet portion 17a between the connector 14 and printed circuit board 11, such that after insertion the bent finger will be positioned so as to permit electrical contact between the associated spring finger and conductor metallization which would have been isolated if the extending finger had not been bent.  Conversely, it is contemplated that a previously bent finger 20 may be manually straightened prior to insertion of the portion 17a.  Preferably, the insulating sheet is approximately 5 to 15 mils. (thousandths of an inch) in thickness and comprises a sheet of flexible polyester material such as Mylar. When the insulating sheet and extending flexible fingers are formed of such a material in the prefered thickness, it has been found that the flexible fingers can be bent and straightened many times without adverse effects, thus allowing substantial user programming of the binary code assembly 10.

FIG. 3 illustrates the completely assembled binary code assembly 10 wherein a number of the programmable fingers 20 of the sheet 17 have been inserted between the connector 14 and the plurality of conductor metallizations 12 on the printed circuit board 11. It should be noted that the metallic connector 14 has a pair of peripheral upstanding locating projections 22 which mate with locating notches 23 formed in the insulating sheet 17 so as to fix the position of the insulating sheet 17 with respect to the connector 14 after the insertion of the sheet portion 17a between the connector and printed circuit board. This also prevents any inadvertent shifting of the insulating sheet 17 with respect to the assembly due to vibration of the finished assembly.

It should be noted that the connector 14 is preferably contemplated as comprising a standard flat cable connector clip number 62871 manufactured by the AMP Company of Harrisburg, Pennsylvania, USA. Normally, the AMP connector clip is utilized to provide a plurality of individual spring finger mechanical biases to the backside of conductors on a flat cable to insure a pressure mechanical and electrical contact between these cable conductors and mating printed circuit board metallizations. Thus, the normal use of the AMP connector clip does not provide a binary code assembly according to the teachings of the present invention, and certainly does not provide a programmable binary code assembly according to the teachings of the present invention.

The insulating sheet 17 illustrated in FIGS. 1 through 3, comprises the central solid carrier strip area 21 and two sets of pluralities of flexible fingers which extend outward in opposite directions from this central solid area. One of these sets of flexible fingers comprise the fingers 20 of the portion 17a as described previously and another set of identical flexible fingers 24 is illustrated as extending in substantially the opposite direction to the fingers 20 and comprising a portion 17b. Either of the portions 17a or 17b can be utilized for insertion between the connector 14 and the printed circuit board 11. The directions of extension referred to are taken prior to any selective bending of any of the extending fingers wherein in a non-bent state of the flexible fingers, the configuration of the insulating sheet 17 is substantially planar.

FIG. 6 illustrates an alternative embodiment for the insulating sheet 17 wherein a sheet 25 illustrated therein comprises one set of flexible extending fingers 26 which extend in a first direction and a selectively notched portion 27 of the sheet 25 extending in an opposite direction wherein the selectively notched portion of the sheet corresponds to a fixed (non-programmable) binary code. Through the use of the insulating sheet 25 shown in FIG. 6, either a predetermined fixed binary code can be implemented or any desired binary code can be implemented depending upon whether either the notched portion 27 or the programmable extending fingers 26 are inserted between the spring fingers 16 and the conductor metallizations 12 on the printed circuit board.

FIG. 5 illustrates that preferably each of the spring fingers 16 has a curved surface 28 which is located adjacent to each printed circuit board conductor metallization 12 associated with a spring finger 16. The purpose of the curved surface 28 is to facilitate the insertion of a portion of the sheet 17 or 25 between the spring fingers 16 and the conductor metallizations 12 when this is desired. The curved surface 28 facilitates this insertion by forming a desired cam surface which will be contacted by an end of the insulating sheet 17 or 25 upon insertion of portions of these sheets between the connector 14 and printed ·circuit board 11. It should also be noted that preferably a special tool may be used to simultaneously lift the spring fingers 16 by inserting a plate in the rear of the connector 14 so as to latch the end portion 29 of the fingers 16 and lift them to aid in the insertion and removal of the sheet 17.

It should be noted that preferably either the metallization 12 contacted by the finger 30 or the surrounding conductor metallization 13 is connected to a DCreference potential such as ground which thereby provides for grounding the entire metal chassis of the connector 14 which includes the main body portion 15 and individual spring fingers 16. Thus, the present binary code assembly provides for the selective grounding of any of the desired conductor metallizations 12 to provide any desired binary code. Codes implemented by the present invention are readily alterable (programmable) by merely withdrawing the portions of the insulating sheet 17 or 25 from between the connector 14 and printed circuit board 11 and subsequently reinserting the sheet with different ones of the flexible extending fingers 20 or 26 being bent. While binary code assemblies such as the assembly described herein can be used for a number of different purposes, it is contemplated that preferably the binary code assembly of the present invention is used to establish a desired predetermined code for receiver and transmitter devices such as for electronic garage door openers.

While I have shown and described specific embodiments of this invention, further modifications and improvements will occur to those skilled in the art. All such modifications which retain the basic underlying principles disclosed and claimed herein are within the scope of this invention.

I claim:

Claims

1. A binary code assembly comprising:

a circuit board having a plurality of isolated conductor paths thereon;

metallic connector means having a main metallic body and a plurality of individual metallic spring fingers extending from said metallic body and electrically connected thereto, said metallic connector means mounted on said circuit board with each spring finger positioned adjacent to an associated one of said isolated circuit board conductor paths, said metallic connector means mounted such that each of said spring fingers normally matingly electrically and mechanically contacts its associated conductor path via the mechanical bias provided by the spring finger; and

insulating means comprising a relatively thin sheet of insulating material, a portion of said sheet being inserted into a fixed position between said connector means and said circuit board, said insulating means formed to provide for the selective interconnection of some of the circuit board conductor paths while maintaining other of said circuit board conductor paths isolated by said inserted portion being interposed between these conductor paths and their associated spring fingers, thereby creating a binary code through the selective shorting together of said some of circuit board conductor paths.

2. A binary code assembly according to claim 1 wherein said binary code assembly is programmable since said insulating means sheet comprises a plurality of individual flexible fingers of insulating material extending from a central carrier strip portion of said sheet, each insulating finger dimensioned such that it is capable of forming an insulating barrier between an associated pair of circuit board conductor path and adjacent connector spring finger when the insulating finger is inserted between said metallic connector means and said circuit board, and each insulating finger capable of being selectively bent, prior to the insertion of said portion of said sheet between said connector means and circuit board, such that after insertion, the bent finger will be positioned to permit electrical contact between said associated pair of circuit board conductor path and adjacent metallic spring finger.

3. A binary code assembly according to claim 1 wherein said sheet comprises a formed sheet of flexible polyester insulating material.

4. A binary code assembly according to claim 2 wherein said sheet comprises a formed sheet of flexible polyester insulating material.

5. A binary code assembly according to claim 4 wherein said insulating sheet is approximately 5 to 15 mils. in thickness.

6. A binary code assembly according to claim 5 wherein said insulating sheet is Mylar.

7. A binary code assembly according to any of claims 1, 2, or 3 wherein said metallic connector means is a standard flat cable clamp connector which is normally utilized to provide a plurality of individual spring finger mechanical biases to thereby electrically connect conductors on a flat cable to mating conductor metallizations on a printed circuit board.

8. A binary code assembly according to any of claims 1 or 2 wherein said metallic connector means has at least one upstanding locating projection and wherein said insulating sheet has formed therein at least one locating notch which mate with said upstanding projection after said portion of said sheet is inserted between said circuit board and said metallic connector means.

9. A binary code assembly according to claim 2 wherein said insulating sheet has a central carrier strip area, and two sets of pluralities of flexible fingers extend outward from said central carrier area in opposite directions such that either set of fingers can be selectively inserted between said metallic connector means and said circuit board conductor paths.

10. A binary code assembly according to claim 2 wherein said insulating sheet has a central carrier strip area with one set of said plurality of flexible fingers extending outward in a first direction, and with a portion extending in the opposite direction comprising a selectively notched portion of said insulating sheet corresponding to a fixed binary code.

11. A binary code assembly according to claim 1 wherein said metallic connector means comprises a metallic chassis which includes said metallic body and said metallic spring fingers, and wherein said metallic chassis is directly and electrically connected to at least one printed circuit board conductor path via a single spring finger regardless of the electrical connections formed by the other individual extending spring fingers.

12. A binary code assembly according to any of claims 1 or 11 wherein each of said spring fingers has a curved surface positioned adjacent to an associated circuit board conductor path to facilitate the insertion of portions of said insulating sheet therebetween.

0058080

1/2

Fig.1

Fig.3

Fig.4